(19) Europäisches Patentamt
European Patent Office
Office européen des brevets

(11) **EP 4 383 039 A1**

(12) **EUROPEAN PATENT APPLICATION**
published in accordance with Art. 153(4) EPC

(43) Date of publication:
**12.06.2024  Bulletin 2024/24**

(51) International Patent Classification (IPC):
**G05F 1/56** (2006.01)

(21) Application number: **22851937.7**

(22) Date of filing: **22.07.2022**

(86) International application number:
**PCT/CN2022/107510**

(87) International publication number:
**WO 2023/011223 (09.02.2023 Gazette 2023/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.08.2021  CN 202110901987**

(71) Applicant: **Vanchip (Tianjin) Technology Co. Ltd Tianjin 300457 (CN)**

(72) Inventors:
• **LI, Chunling**
  **Tianjin 300457 (CN)**
• **WANG, Yongshou**
  **Tianjin 300457 (CN)**
• **CHEN, Cheng**
  **Tianjin 300457 (CN)**
• **LIN, Sheng**
  **Tianjin 300457 (CN)**

(74) Representative: **Wang, Bo**
  **Panovision IP**
  **Ebersberger Straße 3**
  **85570 Markt Schwaben (DE)**

(54) **POWER SUPPLY SUPPRESSION CIRCUIT, CHIP AND COMMUNICATION TERMINAL**

(57)     A power supply suppression circuit (10), a chip and a communication terminal that do not introduce additional DC power consumption, and only achieve the enhancement of the power supply suppression capability from an AC, without generating additional circuit power consumption. The power supply suppression circuit (10) comprises a sampling unit (105), a compensation unit (106), and an amplification unit (107). The sampling unit (105) is connected to the compensation unit (106), and the compensation unit (106) is connected to the amplification unit (107). The power supply suppression circuit (10) obtains an AC signal from a preset sampling node position of a low dropout regulator, and generates an enhancement signal in phase with the AC signal on a power supply (Vdd) on the basis of the AC signal, such that the input end voltage of the power output stage of the low dropout regulator immediately follows the voltage change of the power supply (Vdd) to suppress the power supply noise.

FIG. 1

**Description**

**BACKGROUND**

**Technical Field**

The present invention relates to the field of integrated circuit technologies, and relates to a power supply suppression circuit, and to an integrated circuit chip including the power supply suppression circuit and a corresponding communication terminal.

**Related Art**

With development of integrated circuit technologies, circuits are required to have high system accuracy, and are also required to have a strong suppression effect on power supply noise. In particular, in the fields such as video surveillance and communication system, requirements for a capability of suppressing noise on a power supply voltage are even more demanding. As a common voltage conversion module, a low dropout regulator (LDO) has always attracted much attention for a capability of suppressing power supply noise.

**SUMMARY**

A primary technical problem to be solved by the present invention is to provide a power supply suppression circuit.

Another technical problem to be solved by the present invention is to provide a chip including a power supply suppression circuit and a communication terminal.

To achieve the above objectives, the following of technical solutions are used in the present invention.

According to a first aspect in an embodiment of the present invention, a power supply suppression circuit is provided, including a sampling unit, a compensation unit, and an amplification unit. The sampling unit is connected to the compensation unit, and the compensation unit is connected to the amplification unit.

A first AC signal within a target frequency band is obtained from a preset sampling node position of a low dropout regulator by using the sampling unit and is outputted to the compensation unit. After the compensation unit calculates a difference between the first AC signal and a second AC signal obtained from an error amplification stage of the low dropout regulator, a third AC signal in phase or out of phase with a power supply voltage is obtained and is outputted to the amplification unit. An enhanced signal in phase with an AC signal on a power supply is generated and outputted to an output end of the error amplification stage of the low dropout regulator, so that a variation of a voltage of an input end of a power output stage of the low dropout regulator closely follows a variation of the power supply voltage, to suppress a voltage outputted by the low dropout regulator from varying with the power supply voltage within the target frequency band.

Preferably, the preset sampling node position is any one of a node position an output port of the low dropout regulator, a node position the power supply voltage or a ground cable connected to the low dropout regulator, and a node position on the low dropout regulator where an AC signal of an input end of a power output stage of the low dropout regulator is directly or indirectly controlled.

Preferably, the sampling unit includes a second resistor, a third capacitor, a third resistor, a fourth resistor, and a fifth resistor. One end of the third resistor is connected to an output port of the low dropout regulator. The other end of the third resistor is connected to one end of the third capacitor and one end of the fourth resistor. The other end of the third capacitor is connected to one end of the second resistor. The other end of the fourth resistor is grounded via the fifth resistor. The other end of the second resistor is connected to an input end of the compensation unit.

Preferably, the sampling unit includes a sixth resistor and a fourth capacitor. One end of the fourth capacitor is connected to a ground cable end connected to the low dropout regulator. The other end of the fourth capacitor is connected to one end of the sixth resistor. The other end of the sixth resistor is connected to an input end of the compensation unit.

Preferably, the compensation unit is implemented by using a fifth PMOS transistor. A gate end of the fifth PMOS transistor is connected to an output end of the sampling unit. A source end of the fifth PMOS transistor is connected to the power supply voltage. A drain end of the fifth PMOS transistor is connected to an input end of the amplification unit.

Preferably, the amplification unit includes a fourth NMOS transistor and the fifth PMOS transistor. A drain end of the fourth NMOS transistor is connected to the drain end of the fifth PMOS transistor and a gate end of a sixth PMOS transistor. A gate end of the fourth NMOS transistor is connected to a gate end and a drain end of a second NMOS transistor of the low dropout regulator. A source end of the fourth NMOS transistor is grounded.

Preferably, the sampling unit includes a seventh resistor and a fifth capacitor. One end of the fifth capacitor is connected to the power supply voltage connected to the low dropout regulator. The other end of the fifth capacitor is connected to one end of the seventh resistor. The other end of the seventh resistor is connected to an input end of the compensation unit.

Preferably, the compensation unit is implemented by using a third NMOS transistor. A gate end of the third NMOS transistor is connected to an output end of the sampling unit. A drain end of the third NMOS transistor is connected to an input end of the amplification unit. A source end of the third NMOS transistor is grounded.

Preferably, the amplification unit includes a fourth PMOS transistor, a fifth PMOS transistor, a fourth NMOS transistor, and the third NMOS transistor. A drain end of the fourth PMOS transistor is connected to a gate end of the fourth PMOS transistor and the drain end of the third NMOS transistor. The gate end of the fourth PMOS transistor is connected to a gate end of the fifth PMOS transistor. A source end of the fourth PMOS transistor and a source end of the fifth PMOS transistor are connected to the power supply voltage. A drain end of the fifth PMOS transistor is connected to a drain end of the fourth NMOS transistor and a gate end of a sixth PMOS transistor. A gate end of the fourth NMOS transistor is connected to a gate end and a drain end of a second NMOS transistor of the low dropout regulator. A source end of the fourth NMOS transistor is grounded.

According to a second aspect in an embodiment of the present invention, an integrated circuit chip is provided. The integrated circuit chip includes the foregoing power supply suppression circuit.

According to a third aspect in an embodiment of the present invention, a communication terminal is provided. The communication terminal includes the foregoing power supply suppression circuit.

The power supply suppression circuit provided in the present invention obtains an AC signal from a preset sampling node position of a low dropout regulator, and generates an enhanced signal in phase with an AC signal on a power supply based on the AC signal, so that a variation of an input end voltage of a power output stage of the low dropout regulator closely follows a variation of a power supply voltage to suppress power supply noise. The present invention does not introduce additional DC power consumption, and only implements enhancement of a power supply suppression capability from an AC without generating additional circuit power consumption.

## BRIEF DESCRIPTION OF THE DRAWINGS

FIG. 1 is a brief diagram of a circuit of a power supply suppression circuit applied to a low dropout regulator according to an embodiment of the present invention;

FIG. 2a is a detailed diagram of a circuit of a power supply suppression circuit applied to a low dropout regulator according to Embodiment 1 of the present invention;

FIG. 2b is a diagram of a small signal equivalent model of the circuit in FIG. 2a;

FIG. 3 is a detailed diagram of a circuit of a power supply suppression circuit applied to a low dropout regulator according to Embodiment 2 of the present invention;

FIG. 4 is a detailed diagram of a circuit of a power supply suppression circuit applied to a low dropout regulator according to Embodiment 3 of the present invention;

FIG. 5 is a circuit diagram of a low dropout regulator not connected to a sampling unit of a power supply suppression circuit according to an embodiment of the present invention;

FIG. 6 is a schematic diagram of a simulation result of a power supply suppression circuit according to an embodiment 1 of this invention; and

FIG. 7 is a schematic diagram of a communication terminal using the power supply suppression circuit.

## DETAILED DESCRIPTION

The following describes technical contents of the present invention in detail with reference to accompanying drawings and specific embodiments.

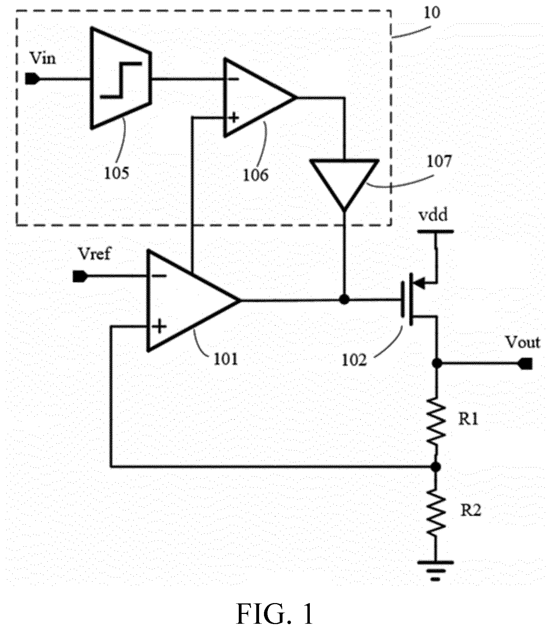

When there is AC (alternating current) noise with a specific frequency on a power supply, an AC noise component with a specific amplitude is inevitably generated at an output port of a low dropout regulator. A gain of the AC noise from the power supply to the output port of the low dropout regulator is mainly determined by a low-frequency gain of the low dropout regulator at a low frequency, and is mainly determined by output capacitance and parasitic capacitance of the low dropout regulator at a high frequency, while at an intermediate frequency, power supply suppression of the low dropout regulator tends to deteriorate as a frequency increases. To prevent a voltage outputted by the low dropout regulator from varying with a power supply voltage within a target frequency band, and to effectively suppress power supply noise within the target frequency band, as shown in FIG. 1, an embodiment of the present invention provides a power supply suppression circuit 10, including a sampling unit 105, a compensation unit 106, and an amplification unit 107. The sampling unit 105 is connected to the compensation unit 106, and the compensation unit 106 is connected to the amplification unit 107.

A first AC signal within a target frequency band is obtained, by using the sampling unit 105, from a preset sampling node position of a low dropout regulator on which power supply suppression is to be performed, and is outputted to the compensation unit 106 (that is, a port B in FIG. 1). After the compensation unit 106 calculates a difference between the first AC signal and a second AC signal obtained from an error amplification stage (101 in FIG. 1) of the low dropout regulator (in other words, calculates a difference between the first AC signal of the port B and the second AC signal of a port C in FIG. 1), a third AC signal in phase or out of phase with a power supply voltage is generated and is outputted to the amplification unit 107 (that is, a port D in FIG. 1), and an enhanced signal in phase with an AC signal on a power supply is generated and is outputted to an output end of the error amplification stage of the low dropout regulator, so that a variation of a voltage of an input end (that is, a gate end of a power transistor M1 in FIG. 1) of a power output stage (102 in FIG. 1) of the low dropout regulator closely follows a variation of the power supply voltage, to suppress a voltage outputted by an output port (an output port Vout in FIG. 1) of the low dropout regulator from varying with the power supply voltage within the target frequency band, thereby improving a power supply suppression capability of the low dropout regulator.

The preset sampling node position of the low dropout regulator to which the sampling unit 105 is connected may be any one of a node position the output port of the low dropout regulator, a node position the power supply voltage or a ground cable connected to the low dropout regulator, and a node position on the low dropout regulator where an AC signal of the input end of the power output stage of the low dropout regulator may be directly or indirectly controlled.

By using an example in which the sampling unit 105 is respectively connected to the output port of the low dropout regulator and the power supply voltage as well as the ground cable connected to the low dropout regulator, the following describes in details how the power supply suppression circuit 10 prevents the voltage outputted by the low dropout regulator from varying with the power supply voltage within the target frequency band. In the present invention, to reduce circuit areas and costs, some components used in units of the power supply suppression circuit 10 may share some components of the low dropout regulator, and a connection relationship of the power supply suppression circuit is designed in combination with the low dropout regulator.

Embodiment 1

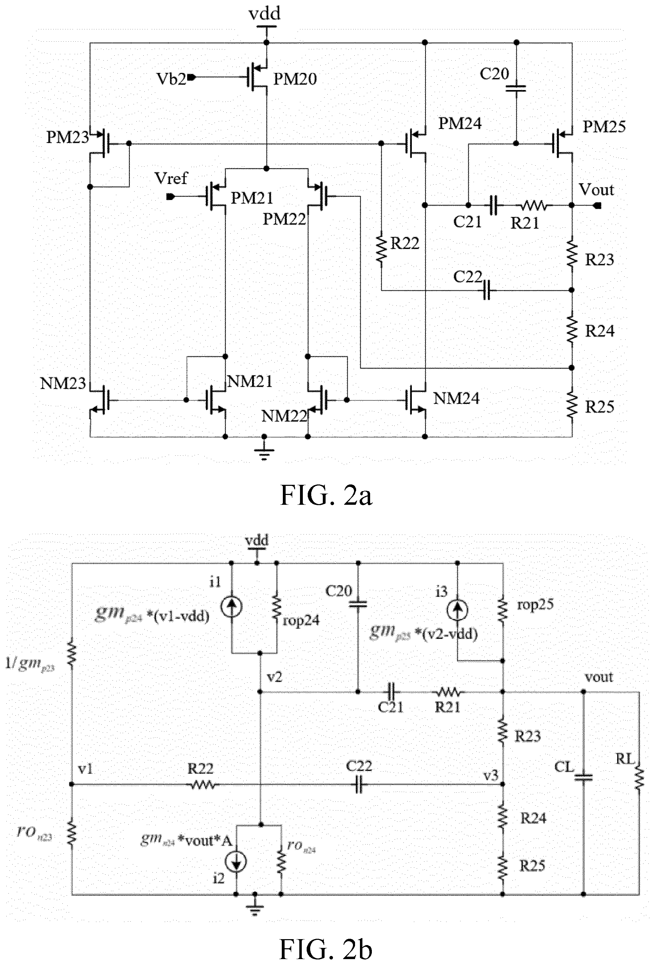

As shown in FIG. 2a, in this embodiment, the sampling unit 105 is connected to an output port Vout of the low dropout regulator. A first PMOS transistor PM20, a second PMOS transistor PM21, a third PMOS transistor PM22, a fourth PMOS transistor PM23, a fifth PMOS transistor PM24, a first NMOS transistor NM21, a second NMOS transistor NM22, a third NMOS transistor NM23, and a fourth NMOS transistor NM24 together constitute the error amplification stage of the low dropout regulator. A sixth PMOS transistor PM25, a first capacitor C20, a second capacitor C21, and a first resistor R21 together constitute the power output stage of the low dropout regulator. A third resistor R23, a fourth resistor R24, and a fifth resistor R25 together constitute a feedback stage of the low dropout regulator. A connection relationship between various components of the low dropout regulator is an existing mature technology. Details are not described again.

As shown in FIG. 2a, the sampling unit 105 includes a second resistor R22, a third capacitor C22, the third resistor R23, the fourth resistor R24, and the fifth resistor R25. One end of the third resistor R23 is used as an input end (an input end Vin in FIG. 1) of the sampling unit 105, and is configured to be connected to the output port Vout of the low dropout regulator. The other end of the third resistor R23 is connected to one end of the third capacitor C22 and one end of the fourth resistor R24. The other end of the third capacitor C22 is connected to one end of the second resistor R22. The other end of the fourth resistor R24 are grounded through the fifth resistor R25. The other end of the second resistor R22 is used as an output port of the sampling unit 105, and is configured to be connected to an input end of the compensation unit 106.

As shown in FIG. 2a, the compensation unit 106 is implemented by using the fifth PMOS transistor PM24. A gate end of the fifth PMOS transistor PM24 is used as the input end of the compensation unit 106, and is configured to be connected to the output end of the sampling unit 105. A source end of the fifth PMOS transistor PM24 is connected to a power supply voltage vdd. A drain end of the fifth PMOS transistor PM24 is used as an output end of the compensation unit 106, and is connected to an input end of the amplification unit 107.

As shown in FIG. 2a, the amplification unit 107 includes the fourth NMOS transistor NM24 and the fifth PMOS transistor PM24 of the compensation unit 106. A drain end of the fourth NMOS transistor NM24 is connected to the drain end (as the output port of the error amplification stage of the low dropout regulator) of the fifth PMOS transistor PM24 and a gate end (as the input end of the power output stage of the low dropout regulator) of the sixth PMOS transistor PM25. A gate end of the fourth NMOS transistor NM24 is connected to a gate end and a drain end of the second NMOS transistor NM22 of the low dropout regulator. A source end of the fourth NMOS transistor NM24 is grounded.

By adjusting a bandwidth of a frequency-selective loop constituted by the second resistor R22 and the third capacitor C22 of the sampling unit 105, a first AC signal within a target frequency band is sampled from the output port Vout of the low dropout regulator, and is loaded into the gate end of the fifth PMOS transistor PM24. After the first AC signal is used in calculating a difference with a second AC signal on the power supply voltage vdd at the source end of the fifth PMOS transistor PM24, an appropriate amplitude amplification is performed by using a gain loop constituted by the fifth PMOS transistor PM24 and the fourth NMOS transistor NM24 connected in parallel, to enable an amplified signal to be in phase with an AC signal on a power supply. To be specific, an enhanced signal in phase with the AC signal on the power supply is obtained, so that a variation of a gate end voltage of the sixth PMOS transistor PM25 of the power output stage of the low dropout regulator closely follows a variation of the power supply voltage within the target frequency band, to suppress power supply noise by the low dropout regulator.

A suppression effect of the power supply suppression circuit 10 on the power supply noise is described in detail as follows.

When a disturbance voltage with a specific frequency on the power supply increases, a disturbance voltage at the output port Vout of the low dropout regulator inevitably increases. To reduce a disturbance voltage amplitude of the output port Vout of the low dropout regulator to enable the disturbance voltage not to vary with the power supply voltage, the gate end voltage of the sixth PMOS transistor PM25 needs to vary with a source end voltage (that is, the power supply voltage) of the sixth PMOS transistor. If the gate end voltage of the sixth PMOS transistor PM25 can desirably vary with the power supply voltage, the output port Vout of the low dropout regulator does not vary with the power supply voltage.

When a disturbance voltage within a specific frequency range is generated on the power supply, a gate end voltage vg24 of the fifth PMOS transistor PM24 varies with the power supply voltage. Due to a reverse effect of the PMOS transistor, a variation of a drain end voltage vd24 of the fifth PMOS transistor PM24 is opposite to a variation of the gate end voltage vg24 of the fifth PMOS transistor, while a variation of the gate end voltage of the sixth PMOS transistor PM25 is the same as a variation of a drain-source voltage vds24 of the fifth PMOS transistor PM24. In this embodiment, to enable the gate end voltage of the sixth PMOS transistor PM25 to vary with the power supply voltage, the gate end voltage of the PMOS transistor PM24 is configured to directly not to vary or slightly vary with the power supply voltage, and the drain end voltage vd24 of the fifth PMOS transistor PM24 is configured to vary with the power supply voltage, so that the gate end voltage of the sixth PMOS transistor PM25 can vary with the power supply voltage. In this way, an objective that the output port Vout of the low dropout regulator does not vary with the power supply voltage can be achieved. For example, as the disturbance voltage of the power supply increases, the gate end voltage vg24 of the fifth PMOS transistor PM24 is reduced due to an effect of the sampling unit 105, so that a gate-source voltage vgs24 of the fifth PMOS transistor PM24 is reduced, leading to an increased compensation current generated by the fifth PMOS transistor PM24 and an increasing gate end voltage of the sixth PMOS transistor PM25. In this case, an impact of a gate-source voltage of the sixth PMOS transistor PM25 varying with the disturbance voltage on the power supply is reduced, and a power supply suppression characteristic of the circuit is improved in the frequency range.

The following describes the technical principle from a mathematical perspective by using a small signal model of the circuit.

FIG. 2b shows a small signal equivalent model of the circuit in FIG. 2a. For the convenience of analysis, it is assumed that reference ends Vb2 and Vref are noise-free, in other words, are alternating current grounded. Therefore, the PMOS transistors PM20, PM21, and the NMOS transistor NM21 may not be taken into account. A capacitor CL and a resistor RL are respectively a load capacitor and a load resistor of the output port Vout of the low dropout regulator. In addition, an AC signal gain from the output port Vout to the gate end of the fourth NMOS transistor NM24 is denoted as A. Therefore, A may be expressed as

$$A = \frac{R_{25}}{R_{23} + R_{24} + R_{25}} * gm_{p22} * \left( ro_{p22} // \frac{1}{gm_{n22}} \right) \qquad (1).$$

In the foregoing formula, $gm_{p22}$ is a small signal gain of the third PMOS transistor PM22 (related to a process parameter and a circuit design parameter), $ro_{p22}$ is small signal impedance of the third PMOS transistor PM22, $gm_{n22}$ is a small signal gain of the second NMOS transistor NM22, and // is a parallel symbol in the circuit.

When a frequency-selective loop constituted by the second resistor R22 and the third capacitor C22 is not taken into account, a small signal voltage at a node v1 is

$$v1 = ro_{n23} * \left( \frac{vdd}{ro_{n23} + \frac{1}{gm_{p23}}} \right) \approx vdd \qquad (2).$$

In the foregoing formula, $ro_{n23}$ is small signal impedance of the third NMOS transistor NM23, and $gm_{p23}$ is a small signal gain of the fourth PMOS transistor PM23. $ro_{n23}$ is much greater than $gm_{p23}$.

Therefore, as shown in FIG. 2b, an AC current $i1$ generated by an inherent gain $gm_{p24}$ of the fifth PMOS transistor PM24 is almost 0, that is,

$$i1 = gm_{p24} * (v1 - vdd) \approx 0 \tag{3}.$$

Therefore, when the frequency-selective loop is not taken into account, an AC voltage amplitude of a node v2 may be approximately expressed as Formula (4). To simplify calculation, an AC current from the node v2 to the output port Vout and an AC current caused by the variation of the power supply vdd and flowing through both impedance $ro_{p24}$ of the fifth PMOS transistor PM24 and impedance $ro_{n24}$ of the fourth NMOS transistor NM24 are omitted herein:

$$v2 \approx gm_{n24} * vout * A * ro_{n24} \tag{4}.$$

In the foregoing formula, $gm_{n24}$ is a small signal gain of the fourth NMOS transistor NM24.

It may be learned that an AC current caused by an inherent gain $gm_{p25}$ of the sixth PMOS transistor PM25 is:

$$i3 = gm_{p25} * (v2 - vdd) \tag{5}.$$

Therefore, it may be learned that an AC voltage component at the output port Vout of the low dropout regulator caused by the variation of the gate-source voltage of the sixth PMOS transistor PM25 is:

$$vout = \left( R_L \mathbin{/\mkern-5mu/} \frac{1}{sC_L} \mathbin{/\mkern-5mu/} (R_{23} + R_{24} + R_{25}) \right) * i3 \tag{6}.$$

When the frequency-selective loop constituted by the second resistor R22 and the third capacitor C22 is introduced, a voltage variation component of the node v1 is reduced. This is caused by a current flowing through impedance $ro_{n23}$ of the third NMOS transistor NM23 being shunted by the frequency-selective loop. When the frequency-selective loop is taken into account, an AC voltage component of a node v3 is approximately:

$$v3 = \frac{R_{24} + R_{25}}{R_{23} + R_{24} + R_{25}} * vout \tag{7}.$$

Therefore, from the node v1 to the node v3, a current flowing through the frequency-selective loop is:

$$i_{R22} = \left. (v1' - v3) \middle/ \left( R_{22} + \frac{1}{sC_{22}} \right) \right. \tag{8}.$$

$v1'$ is a small signal voltage of the node v1 when the frequency-selective loop is taken into account. It may be learned from Formula (2) that when there is no frequency-selective loop, a voltage of the node v1 is close to the power supply voltage vdd, while a voltage of the node v3 is a smaller voltage value. Therefore, when the frequency-selective loop is added, the current flows from the node v1 to the node v3, so that $i_{R22}$ is greater than zero.

Therefore, the small signal voltage of the node v1 may be re-expressed as:

$$v1' = ro_{n23} * \left( \frac{vdd}{ro_{n23} + 1 \middle/ gm_{p23}} - i_{R22} \right) < vdd \tag{9}.$$

Therefore, it may be learned from Formula (3) that

$$|i1'| = |gm_{p24} * (v1'-vdd)| > 0 \qquad (10).$$

By adding a frequency-selective loop, an AC current component of the fifth PMOS transistor PM24 increases. In other words, a voltage component of the node v2 increases, so that

$$v2' = (gm_{n24}*vout*A + i1')*ro_{n24} > v2 \qquad (11).$$

Therefore, an AC voltage component of the node v2 is closer to vdd because of an effect of addition of the frequency-selective loop. At a specific frequency point, the node v2 varies with the power supply vdd, that is,

$$v2' \rightarrow vdd$$
$$\Rightarrow \quad i3' \rightarrow 0 \qquad (12).$$
$$\Rightarrow \quad vout' \rightarrow 0$$

Therefore, an AC current component i3' caused by a small signal gain of the sixth PMOS transistor PM25 decreases or even drops to 0, so that an AC component of an output port vout' drops to 0. In other words, when the power supply voltage varies, an output of the low dropout regulator remains unchanged, so that the power supply noise can be suppressed.

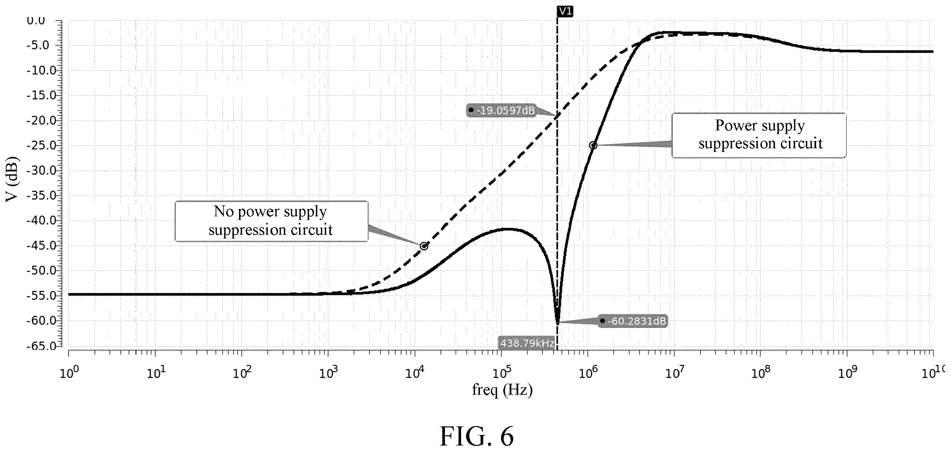

FIG. 6 shows a simulation result of Embodiment 1. A dashed line in the figure is a simulation result of power supply suppression without adding the power supply suppression circuit, and a solid line is a simulation result of power supply suppression after the power supply suppression circuit is added. It may be learned from the simulation results that the power supply suppression circuit can effectively suppress power supply noise within a wide frequency range. At a position where suppression is strongest, a frequency point can be selected by adjusting a circuit parameter. In this figure, at a position where suppression is strongest, power supply suppression is improved by about 40 dB compared with an original circuit.

Embodiment 2

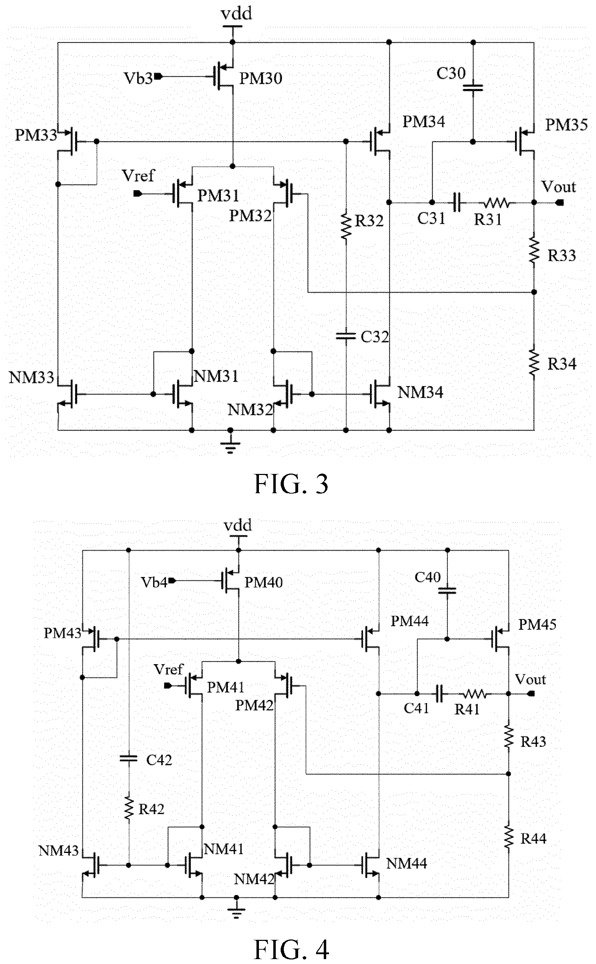

As shown in FIG. 3, in this embodiment, the sampling unit 105 is connected to a ground cable end connected to the low dropout regulator. A difference between this embodiment and Embodiment 1 lies in that the sampling unit 105 includes a sixth resistor R32 and a fourth capacitor C32. One end of the fourth capacitor C32 is used as an input end of the sampling unit 105, and is configured to be connected to the ground cable end connected to the low dropout regulator. The other end of the fourth capacitor C32 is connected to one end of the sixth resistor R32. The other end of the sixth resistor R32 is used as an output port of the sampling unit 105, and is configured to be connected to an input end of the compensation unit 106.

It can be learned from descriptions of Embodiment 1 that to suppress power supply noise within a target frequency band, it is necessary that a variation of a gate end (a PMOS transistor PM35 in FIG. 3) voltage of a PMOS transistor of the power output stage of the low dropout regulator closely follows a variation of a power supply voltage within the frequency band. Therefore, an AC current of a PMOS transistor PM34 needs to increase. Due to a voltage dividing function of a PMOS transistor PM33 and an NMOS transistor NM33, a variation of a gate end voltage of the PMOS transistor PM34 closely follows the variation of the power supply voltage. Therefore, an implementation idea described in Embodiment 1 is used to shunt an AC current flowing through the NMOS transistor NM33, so that an AC voltage component at a gate end of the PMOS transistor PM34 can be reduced, thereby suppressing power supply noise. An implementation method used in this embodiment is to introduce an RC frequency-selective loop constituted by the sixth resistor R32 and the fourth capacitor C32 between the gate end of the PMOS transistor PM34 and the ground, to increase a compensation current flowing through the PMOS transistor PM34 within a target frequency band, to enable a gate end voltage of the PMOS transistor PM35 to vary with the power supply voltage within a selected frequency band, so as to suppress power supply noise. A specific working principle of this embodiment is similar to that of Embodiment 1. Details are not described herein again.

Embodiment 3

As shown in FIG. 4, in this embodiment, the sampling unit 105 is connected to a power supply voltage connected to the low dropout regulator. A difference between this embodiment and Embodiment 1 and Embodiment 2 lies in that both Embodiment 1 and Embodiment 2 directly control a gate end of a PMOS transistor PM44 (a PMOS transistor PM24 in FIG. 2a and a PMOS transistor PM34 in FIG. 3), however, in this embodiment, a gate end voltage of a PMOS transistor PM45 indirectly varies with the power supply voltage within a target frequency band, to suppress power supply noise within the target frequency band. The sampling unit 105 includes a seventh resistor R42 and a fifth capacitor C42. One end of the fifth capacitor C42 is used as an input end of the sampling unit 105, and is configured to be connected to the power supply voltage connected to the low dropout regulator. The other end of the fifth capacitor C42 is connected to one end of the seventh resistor R42. The other end of the seventh resistor R42 is used as an output port of the sampling unit 105, and is configured to be connected to an input end of the compensation unit 106.

As shown in FIG. 2a, the compensation unit 106 is implemented by using a third NMOS transistor NM23 (an NMOS transistor NM43 in FIG. 4). A gate end of the third NMOS transistor NM23 is used as the input end of the compensation unit 106, and is configured to be connected to the output end of the sampling unit 105. A drain end of the third NMOS transistor NM23 is used as an output end of the compensation unit 106, and is configured to be connected to an input end of the amplification unit 107. A source end of the third NMOS transistor NM23 is grounded.

As shown in FIG. 2a, the amplification unit 107 includes a fourth PMOS transistor PM23, a fifth PMOS transistor PM24, a fourth NMOS transistor NM24 (PMOS transistors PM43, PM44, and an NMOS transistor NM44 in FIG. 4), and the third NMOS transistor NM23 of the compensation unit 106. A drain end of the fourth PMOS transistor PM23 is connected to a gate end of the fourth PMOS transistor and the drain end of the third NMOS transistor NM23. The gate end of the fourth PMOS transistor PM23 is connected to a gate end of the fifth PMOS transistor PM24. A source end of the fourth PMOS transistor PM23 and a source end of the fifth PMOS transistor PM24 are connected to the power supply voltage vdd. A drain end of the fifth PMOS transistor PM24 is connected to a drain end of the fourth NMOS transistor NM24 and a gate end of a sixth PMOS transistor PM25 (the PMOS transistor PM45 in FIG. 4). A gate end of the fourth NMOS transistor NM24 is connected to a gate end and a drain end of a second NMOS transistor NM22 (a PMOS transistor PM42 in FIG. 4) of the low dropout regulator. A source end of the fourth NMOS transistor NM24 is grounded.

To implement that a gate end voltage of the PMOS transistor PM44 does not vary with the power supply voltage or a variation of a gate end voltage of the PMOS transistor does not closely follow a variation of the power supply voltage, this embodiment provides a method that an RC frequency-selective loop constituted by the seventh resistor R42 and the fifth capacitor C42 is structured between a gate end of the NMOS transistor NM43 transistor of the error amplification stage of the low dropout regulator and the power supply. Therefore, when an AC signal is generated on the power supply, the RC frequency-selective loop transmits the AC signal within the target frequency band to the gate end of the NMOS transistor NM43 by a function of frequency selection, to enable a gate end voltage of the NMOS transistor to vary with the power supply voltage. This variation causes a voltage variation out of phase at a drain end of the NMOS transistor NM43, that is, the gate end of the PMOS transistor PM44, so that a phenomenon that the gate end voltage of the PM44 transistor varies with the power supply voltage can be suppressed. According to content of Embodiment 1 and Embodiment 2, power supply noise can be suppressed within a target frequency band.

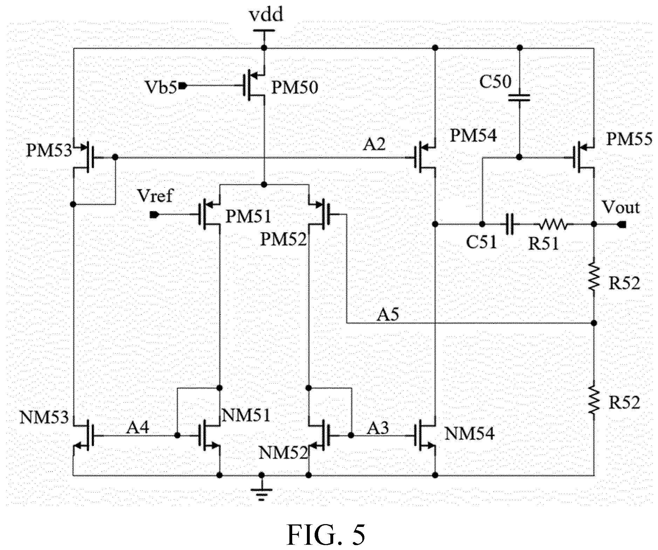

In addition, as shown in FIG. 5, in addition to a direct manner in Embodiment 1 and Embodiment 2 in which a gate end voltage of a PMOS transistor PM54 is configured to directly not to vary or slightly vary with the power supply voltage, an indirect manner may alternatively be used. In other words, the sampling unit is connected to a node position on the low dropout regulator where an AC signal at the input end of the power output stage of the low dropout regulator is indirectly controlled to vary with the power supply voltage. Specifically, the sampling unit is provided between a node A2 and a node A4 in FIG. 5, or the sampling unit is provided between a reference voltage Vref and the ground. When the indirect manner is used to enable a gate end voltage of a PMOS transistor PM55 to vary with the power supply voltage, the sampling unit may alternatively be connected to the low dropout regulator to control a gate end of an NMOS transistor NM54 directly or indirectly, so that a gate end voltage of the NMOS transistor is out of phase with the power supply voltage during variation, to enable the gate end voltage of the PMOS transistor PM55 to vary with the power supply voltage. Specifically, the sampling unit may be provided between a node A5 and the power supply or the node A2 in FIG. 5. Similarly, the direct manner may alternatively be used to enable the gate end voltage of the NMOS transistor NM54 to be out of phase with the power supply voltage during variation. Specifically, the sampling unit may be provided between a node A3 and the ground in FIG. 5. The foregoing implementation methods all fall within the technical protection scope of the present invention, and the principles are consistent.

It should be emphasized that the power supply suppression circuit provided in this embodiment of the present invention may also be used in analog and radio frequency circuits with a high power supply suppression requirement, such as an operational amplifier, to implement better power supply suppression. In addition, to reduce circuit areas and costs, a circuit structure of the operational amplifier may also be combined, and a power supply suppression effect of the power supply suppression circuit can be implemented by sharing some devices with the operational amplifier. Details are not described herein again.

In addition, the power supply suppression circuit provided in this embodiment of the present invention may be used in an integrated circuit chip. For a specific structure of the power supply suppression circuit in the integrated circuit chip, details are not described herein again.

The foregoing power supply suppression circuit may also be used in a communication terminal as an important component of a radio frequency integrated circuit. The communication terminal herein refers to a device that may be used in a mobile environment and support a plurality of communications standards, such as GSM, EDGE, TD_SCDMA, TDD_LTE, and FDD_LTE, including a mobile phone, a notebook computer, a tablet computer, an Internet of Vehicles terminal, and the like. In addition, the technical solutions provided in the present invention are also applicable to another application scenario of a radio frequency integrated circuit, such as a communication base station, an intelligent connected vehicle.

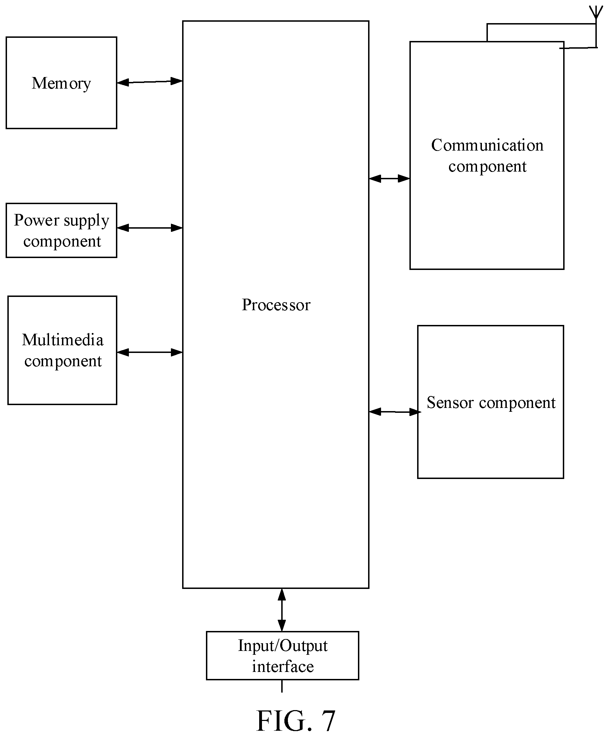

As shown in FIG. 7, the communication terminal includes at least a processor and a memory, and may further include a communication component, a sensor component, a power supply component, a multimedia component, and an input/output interface according to an actual requirement. The memory, the communication component, the sensor component, the power supply component, the multimedia component, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, and the like. The processor may be a central processing unit (CPU), a graphics processing unit (GPU), a field programmable gate array (FPGA), an application-specific integrated circuit (ASIC), a digital signal processing (DSP) chip, and the like. Another communication component, sensor component, power supply component, multimedia component, and the like may all be implemented by using common elements. Details are not described herein.

Compared with conventional technologies, the power supply suppression circuit provided in the present invention obtains an AC signal from a preset sampling node position of a low dropout regulator, and generates an enhanced signal in phase with an AC signal on a power supply based on the AC signal, so that a variation of an input end voltage of a power output stage of the low dropout regulator closely follows a variation of a power supply voltage to suppress power supply noise. The present invention does not introduce additional DC power consumption, and only implements enhancement of a power supply suppression capability from an AC without generating additional circuit power consumption.

The power supply suppression circuit, chip, and communication terminal provided in the present invention are described in detail above. For a person skilled in the art, any obvious changes made to the present invention without departing from the essence of the present invention will fall within the scope of protection of claims of the present invention.

## Claims

1.    A power supply suppression circuit, comprising a sampling unit, a compensation unit, and an amplification unit, wherein the sampling unit is connected to the compensation unit, and the compensation unit is connected to the amplification unit; and
a first AC signal within a target frequency band is obtained from a preset sampling node position of a low dropout regulator by using the sampling unit and is outputted to the compensation unit, after the compensation unit calculates a difference between the first AC signal and a second AC signal obtained from an error amplification stage of the low dropout regulator, a third AC signal in phase or out of phase with a power supply voltage is obtained and is outputted to the amplification unit, and an enhanced signal in phase with an AC signal on a power supply is generated and outputted to an output end of the error amplification stage of the low dropout regulator.

2.    The power supply suppression circuit according to claim 1, wherein
the preset sampling node position is any one of a node position of an output port of the low dropout regulator, a node position of the power supply voltage or a ground cable connected to the low dropout regulator, and a node position on the low dropout regulator where an AC signal of an input end of a power output stage of the low dropout regulator is directly or indirectly controlled.

3.    The power supply suppression circuit according to claim 1, wherein
the sampling unit comprises a second resistor, a third capacitor, a third resistor, a fourth resistor, and a fifth resistor, one end of the third resistor is connected to an output port of the low dropout regulator, the other end of the third resistor is connected to one end of the third capacitor and one end of the fourth resistor, the other end of the third capacitor is connected to one end of the second resistor, the other end of the fourth resistor is grounded via the fifth resistor, and the other end of the second resistor is connected to an input end of the compensation unit.

4.    The power supply suppression circuit according to claim 1, wherein
the sampling unit comprises a sixth resistor and a fourth capacitor, one end of the fourth capacitor is connected to a ground cable end connected to the low dropout regulator, the other end of the fourth capacitor is connected to one end of the sixth resistor, and the other end of the sixth resistor is connected to an input end of the compensation unit.

5. The power supply suppression circuit according to claim 3 or 4, wherein
the compensation unit is implemented by using a fifth PMOS transistor, a gate end of the fifth PMOS transistor is connected to an output end of the sampling unit, a source end of the fifth PMOS transistor is connected to the power supply voltage, and a drain end of the fifth PMOS transistor is connected to an input end of the amplification unit.

6. The power supply suppression circuit according to claim 5, wherein
the amplification unit comprises a fourth NMOS transistor and the fifth PMOS transistor, a drain end of the fourth NMOS transistor is connected to the drain end of the fifth PMOS transistor and a gate end of a sixth PMOS transistor, a gate end of the fourth NMOS transistor is connected to a gate end and a drain end of a second NMOS transistor of the low dropout regulator, and a source end of the fourth NMOS transistor is grounded.

7. The power supply suppression circuit according to claim 1, wherein
the sampling unit comprises a seventh resistor and a fifth capacitor, one end of the fifth capacitor is connected to the power supply voltage connected to the low dropout regulator, the other end of the fifth capacitor is connected to one end of the seventh resistor, and the other end of the seventh resistor is connected to an input end of the compensation unit.

8. The power supply suppression circuit according to claim 7, wherein
the compensation unit is implemented by using a third NMOS transistor, a gate end of the third NMOS transistor is connected to an output end of the sampling unit, a drain end of the third NMOS transistor is connected to an input end of the amplification unit, and a source end of the third NMOS transistor is grounded.

9. The power supply suppression circuit according to claim 8, wherein
the amplification unit comprises a fourth PMOS transistor, a fifth PMOS transistor, a fourth NMOS transistor, and the third NMOS transistor, a drain end of the fourth PMOS transistor is connected to a gate end of the fourth PMOS transistor and the drain end of the third NMOS transistor, the gate end of the fourth PMOS transistor is connected to a gate end of the fifth PMOS transistor, a source end of the fourth PMOS transistor and a source end of the fifth PMOS transistor are connected to the power supply voltage, a drain end of the fifth PMOS transistor is connected to a drain end of the fourth NMOS transistor and a gate end of a sixth PMOS transistor, a gate end of the fourth NMOS transistor is connected to a gate end and a drain end of a second NMOS transistor of the low dropout regulator, and a source end of the fourth NMOS transistor is grounded.

10. An integrated circuit chip, comprising the power supply suppression circuit according to any one of claims 1 to 9.

11. A communication terminal, comprising the power supply suppression circuit according to any one of claims 1 to 9.

FIG. 1

FIG. 2a

FIG. 2b

FIG. 3

FIG. 4

FIG. 5

FIG. 6

FIG. 7

## INTERNATIONAL SEARCH REPORT

| International application No. |
| --- |
| **PCT/CN2022/107510** |

**A.  CLASSIFICATION OF SUBJECT MATTER**

G05F 1/56(2006.01)i

According to International Patent Classification (IPC) or to both national classification and IPC

**B.  FIELDS SEARCHED**

Minimum documentation searched (classification system followed by classification symbols)

G05F

Documentation searched other than minimum documentation to the extent that such documents are included in the fields searched

Electronic data base consulted during the international search (name of data base and, where practicable, search terms used)

CNPAT, CNKI, WPI, EPODOC: 唯捷创芯, 李春领, 线性电源, 低压差线性稳压, 低压线性稳压, 抑制, 防止, 避, 免, 补偿, 抵消, 缓解, 噪音, 噪声, 波动, 波纹, 电源, 交流, AC, LDO, PSRR, power, supply, reject+, ratio, noise, avoid+, prevent+

**C.  DOCUMENTS CONSIDERED TO BE RELEVANT**

| Category* | Citation of document, with indication, where appropriate, of the relevant passages | Relevant to claim No. |
| --- | --- | --- |
| X | CN 110320963 A (BRIGATES MICROELECTRONICS (KUNSHAN) CO., LTD.) 11 October 2019 (2019-10-11)<br>    description, paragraphs [0031]-[0086], and figure 2 | 1-4, 10, 11 |
| Y | CN 110320963 A (BRIGATES MICROELECTRONICS (KUNSHAN) CO., LTD.) 11 October 2019 (2019-10-11)<br>    description, paragraphs [0031]-[0086], and figure 2 | 5-7 |
| X | CN 110632971 A (HARBIN UNIVERSITY OF SCIENCE AND TECHNOLOGY) 31 December 2019 (2019-12-31)<br>    description, paragraphs [0010]-[0015], and figures 1-2 | 1-6, 10, 11 |
| Y | CN 110632971 A (HARBIN UNIVERSITY OF SCIENCE AND TECHNOLOGY) 31 December 2019 (2019-12-31)<br>    description, paragraphs [0010]-[0015], and figures 1-2 | 5-7 |
| PX | CN 113672016 A (VANCHIP (TIANJIN) TECHNOLOGY CO., LTD.) 19 November 2021 (2021-11-19)<br>    claims 1-11, description, paragraphs [0021]-[0048], and figures 1-6 | 1-11 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **08 September 2022** | **28 September 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

# EP 4 383 039 A1

<table>
<tr><td colspan="2" align="center">**INTERNATIONAL SEARCH REPORT**</td><td>International application No.<br>**PCT/CN2022/107510**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| A | CN 112346508 A (WUXI AIWEI INTEGRATED CIRCUIT TECHNOLOGY CO., LTD.) 09 February 2021 (2021-02-09)<br> entire document | 1-11 |
| A | CN 106055012 A (SHANGHAI HUANGYU PHOTOELECTRIC TECHNOLOGY CO., LTD.) 26 October 2016 (2016-10-26)<br> entire document | 1-11 |
| A | US 2010148736 A1 (STMICROELECTRONICS DESIGN AND APPLICATION S.R.O) 17 June 2010 (2010-06-17)<br> entire document | 1-11 |
| A | US 2012212199 A1 (AMER, AHMED et al.) 23 August 2012 (2012-08-23)<br> entire document | 1-11 |
| A | WO 2021104134 A1 (SHENZHEN GOODIX TECHNOLOGY CO., LTD.) 03 June 2021 (2021-06-03)<br> entire document | 1-11 |

Form PCT/ISA/210 (second sheet) (January 2015)

INTERNATIONAL SEARCH REPORT
Information on patent family members

International application No.

**PCT/CN2022/107510**

| Patent document cited in search report | | | Publication date (day/month/year) | Patent family member(s) | | | Publication date (day/month/year) |
|---|---|---|---|---|---|---|---|
| CN | 110320963 | A | 11 October 2019 | CN | 110320963 | B | 13 October 2020 |
| CN | 110632971 | A | 31 December 2019 | None | | | |
| CN | 113672016 | A | 19 November 2021 | CN | 113672016 | B | 18 January 2022 |
| CN | 112346508 | A | 09 February 2021 | None | | | |
| CN | 106055012 | A | 26 October 2016 | None | | | |
| US | 2010148736 | A1 | 17 June 2010 | IT | TO20080934 | A1 | 16 June 2010 |
| | | | | US | 8242761 | B2 | 14 August 2012 |
| | | | | IT | 1392263 | B1 | 22 February 2012 |
| US | 2012212199 | A1 | 23 August 2012 | None | | | |
| WO | 2021104134 | A1 | 03 June 2021 | US | 11036247 | B1 | 15 June 2021 |
| | | | | CN | 114375432 | A | 19 April 2022 |

Form PCT/ISA/210 (patent family annex) (January 2015)